# EUROPEAN PATENT SPECIFICATION

(11) **EP 2 541 771 B1**
(45) Date of publication and mention of the grant of the patent: **12.03.2014**
(21) Application number: 11005387.3
(22) Date of filing: 01.07.2011
(51) Int. Cl.: H03K 17/96, H01H 13/06, H01H 13/88

(54) **Method of manufacturing an electrical switching element**
Verfahren zum Herstellen eines elektrischen Schaltelements
Procédé de fabrication d'un élément de commutation électrique

(43) Date of publication of application: 02.01.2013
(73) Proprietor: Electrolux Home Products Corporation N.V., 1130 Brussel (BE)
(72) Inventor: Weidner, Thomas, 90411 Nürnberg (DE)
(74) Representative: Samzelius, Roger Mikael

(56) References cited:
- WO-A2-01/78236
- DE-A1-102008 052 816
- US-A- 5 917 165

## Description

The present invention relates to a method of manufacturing an electrical switching element.

In electrical switching elements in which a sensor element is mounted on a printed circuit board, there has to be provided for a conductive path between the circuit board and a user interface, such as an operating panel. If the sensor is a capacitive touch sensor, the sensor comprises several individual sensor elements that are mounted on the printed circuit board, to which sensor elements separate conductive paths have to be provided from the user interface, so that touching the user interface causes a change in capacity of the sensor.

In known switching arrangements, providing for a plurality of individual conductive paths, as is required when there is a plurality of sensors or also for a single sensor which comprises a plurality of individual sensor elements, often was difficult to accomplish because a plurality of individual parts had to be assembled.

Document DE 10 2008 052 816 A1 discloses an illuminated proximity/touch switch comprising a sensor element in the form of a flexible conductive body arranged at a top side of a printed circuit board (PCB) between said top side of the PCB and a cover plate.

Document WO 01/78236 A2 discloses a compact non-contact electrical switch for use in an electrical box mounted on a wall having a capacitance sensor for detecting a presence of a hand placed adjacent to the switch.

It is an object of the present invention to provide for a method of manufacturing an electrical switching element which can be carried out in a cost efficient manner In conformity with the present invention this object is solved by a method of manufacturing an electrical switching element, comprising:
(a) providing a housing having at least one opening,
(b) forming at least one connector element by injection molding of a conductive material into said housing, such that the connector element extends through the first opening of said housing and comprises a first end located in the interior of the housing and a second end which terminates at the exterior of the housing;
(c) mounting a circuit board comprising a sensor element to the housing such that the first end of the connector element contacts the sensor element.

Due to the fact that in the method of the present invention the connector element, or if the arrangement comprises a plurality of connector elements, all the connector elements, are formed by injection molding, no separate assembling steps are required for the mounting of the connector elements. Furthermore, in this method the position of the one or more connector elements within the housing is fixed because injection molding the conductive material such that the connector element extends through the first opening of the housing provides for an integral structure comprising the housing and the one or more connector elements.

Preferred embodiments of the present invention are defined in the dependent claims.

The step of providing a housing having at least one opening preferably comprises injection molding a plastics material so as to form the housing. Injection molding not only the connector elements but also the housing provides for a cheap and efficient process which allows manufacturing also complex housing shapes in a cost efficient manner. While different molding devices can be used for manufacturing the plastic housing on the one hand and for forming the connector elements on the other hand, both these steps also can be conducted in a single molding device, provided that such molding device is equipped with means for selectively supplying molding material to selected regions of the mold, such as gates for shutting off selected regions of the mold, or molding devices comprising rotary tables or shifting plates so as to sequentially mold selected regions of the component to be manufactured.

Preferably, the housing is dimensioned so as to accommodate the circuit board so that the housing and the circuit board can be combined to form a unitary assembly.

In preferred embodiments, the housing is provided with means for aligning the circuit board and the housing so as to facilitate assembly of the electrical switching element. Such alignment means can comprise, for example, alignment pins or projections provided at one of the housing and the circuit board, which in the assembled state of the electrical switching element cooperate with respective recesses provided at the respective other one of the housing and circuit board.

In order to prevent misalignment of the circuit board with respect to the housing, the housing and the circuit board preferably are designed such that the circuit board can be arranged within said housing only in a single orientation. This can be accomplished by designing the alignment means to be asymmetric.

In a particularly preferred embodiment, alignment of the housing and the printed circuit board is provided by dimensioning the housing and the circuit board such that the housing fits about the circumference of the circuit board. In this method alignment of the connector elements and the sensor elements provided on the printed circuit board inherently is provided simply by fitting the circuit board into the housing.

The assembly of the electrical switching element can be further facilitated by mounting the circuit board within the housing by snap-fit connection. This can be implemented by providing in the walls of the housing which contact the outer rim of the printed circuit board projections which the printed circuit board has to pass when being inserted into the housing. During insertion of the circuit board the respective region of the housing wall is temporarily deformed, but assumes its original shape as soon as the printed circuit board has passed the projection.

In preferred embodiments, a plurality of openings is formed in the housing and a plurality of connector elements is injection molded into the housing so as to provide for a plurality of conductive paths to a plurality of sensor elements provided on the circuit board. In contrast to known methods of assembling electrical switching elements comprising a plurality of sensor elements, wherein connector elements such as conducting springs were used to provide for a conductive path between each of the sensor elements provided on the circuit board and the user interface, in such embodiments of the present method all the required connector elements can be formed in a single manufacturing step by injecting molding a conductive material into the housing. This embodiment of the present method is particularly suited for forming switching arrangements that comprise a plurality of sensors or which comprise a capacitive sensor that is composed of a plurality of sensor elements the capacity of which changes when a user approaches or touches the respective user interface.

Preferably, upon assembly of the switching element a panel element, which provides for a user interface, is mounted such that the second end of the connector elements, i.e. the end of the connector elements that terminates at the exterior of the housing, terminates at the panel element. In dependency of the type of sensor elements used, the panel element can be made of conductive or non-conductive material. Thus, for example, if the sensor comprises a capacitive sensor the panel element can comprise a thin material layer, such as a glass sheet or a plastic foil, such as PMMA foil, which has sufficient permitivity to allow the sensor elements to detect a change in capacity that is caused by a user approaching or touching the user interface at the panel element.

While for forming the connector elements a variety of materials can be used, preferred materials include conductive rubber or conductive plastics materials.

Preferred embodiments of the present invention are described below by reference to the drawings, in which
- Fig. 1: is a vertical sectional view of an electric switching element during manufacturing;
- Fig. 2: is a vertical sectional view of the switching element of Fig. 1 in the fully assembled state; and
- Fig. 3: is a horizontal sectional view of an electrical switching element manufactured by the method of the present invention.

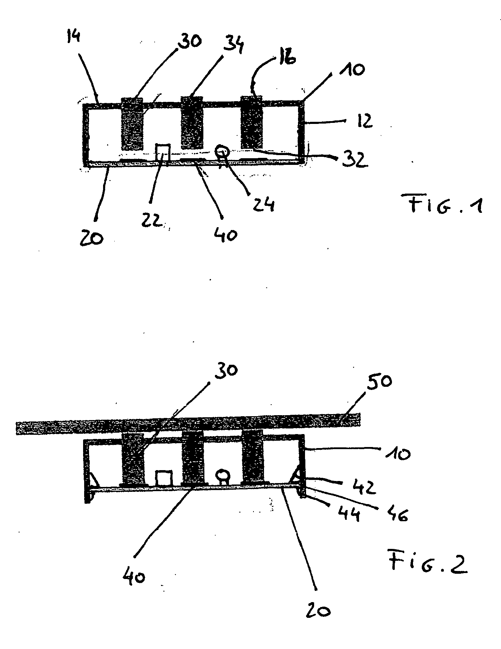

In Fig. 1 there is shown a housing 10 comprising a plurality of sidewalls 12 and a top wall 14 in which there is provided a plurality of openings 16. While housing 10 can be of any shape, in the embodiment shown in Fig. 1 sidewalls 12 and top wall 14 are configured to form a generally rectangular box-shaped housing having an open bottom for accommodating a printed circuit board 20. Circuit board 20 comprises a plurality of sensor elements 40 as well as any desired plurality of further components 22 and 24, which together form a sensor circuitry.

In order to provide for a conductive path between a user interface, which in Fig. 1 will be located at the top wall 14 of housing 10, a plurality of connector elements 30 is provided such that a first end 32 of the connector elements 30 is located in the interior of housing 12 and a second end 34 terminates at the exterior of housing 12.

Since connector elements 30 are formed by injection molding of a conductive material into housing 12, connector elements 30 fill the openings 16 provided in the top wall 14 of housing 10 and thus form an integral unit with housing 12.

Fig. 2 shows the assembly of Fig. 1 when the printed circuit board 20 is in the fully mounted state, i.e. has been inserted further into the interior of housing 12 so that the first ends 32 of connector elements 30 contact the sensor elements 40 provided on printed circuit board 20.

In order to hold printed circuit board 20 in place in the fully assembled position, sidewalls 12 are provided with stops 42 which define how far printed circuit board 20 can be inserted into housing 12. Fixation of printed circuit board 20 within housing 12 is provided by projections 44, which projections the circuit 20 has to pass when being inserted into housing 12. Stops 42 and projections 44 thus cooperate to define a gap 46 for accommodating printed circuit board 20. Instead of providing individual stops 42 and projections 44, which may be located at any desired position within housing 10, sidewalls 12 can be provided with a continuous groove or with a plurality of grooves for accommodating the peripheral rim of printed circuit board 20.

In the embodiment shown in Fig. 2, projections 44 provide for a snap-in connection between housing 10 and printed circuit board 20, wherein pushing printed circuit board 20 into housing 10 past projections 44 causes a temporary deformation of housing 10, wherein housing 10 assumes its original shape as soon as circuit board 20 has passed projections 44.

In Fig. 2 there further is shown a panel element 50 which provides a user interface for activating sensor elements 40. Panel element 50 can be designed to cover a plurality of electrical switching elements and/or to accommodate further operating elements such as switches, displays and the like. In order to provide a user with information as regards operation of the switching element, panel element 50 can be provided with optical indications. Thus, if panel element 50 comprises for example a PMMA foil, and particularly a transparent PMMA foil, it can be printed, for example at its bottom side, so as to provide for an indication where a user should touch panel element 50 so as to activate the electrical switching element.

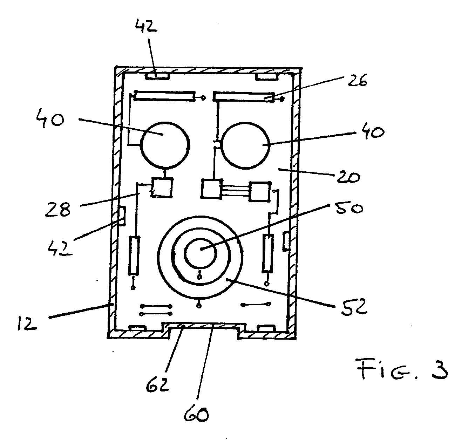

Fig. 3 is a horizontal sectional view of an electrical switching arrangement comprising several sensors which are mounted on a printed circuit board 20 comprising a plurality of electric components 26 which are connected by electric wiring 28. As shown in Fig. 3, the arrangement comprises two sensor elements 40 as well as a circular sensor element 50 which together with a concentric annular sensor element 52 forms a capacitive sensor.

While printed circuit board 20 has a generally rectangular shape, in order to prevent misalignment of the circuit board when fitting it into housing 12 the circuit board at one of its sides comprises a recessed portion 60 which is engaged by corresponding portion 62 of housing side wall 12 which projects inwardly into recessed portion 60.

## Claims

1. Method of manufacturing an electrical switching element, comprising:
a) providing a housing (10) having at least one opening (16),
b) forming at least one connector element (30) by injection molding of a conductive material into said housing (10), such that the connector element extends through the opening (16) of said housing and comprises a first end (32) located in the interior of the housing and a second end (34) which terminates at the exterior of the housing;
c) mounting a circuit board (20) comprising a sensor element (40) to the housing (10) such that the first end (32) of the connector element (30) contacts the sensor element (40).

2. The method of claim 1, in which step a) comprises injection molding a plastics material so as to form said housing (10).

3. The method of claim 1 or 2, in which said housing (10) is dimensioned so as to accommodate said circuit board (20).

4. The method of any one the preceding claims, in which in step a) said housing (10) is provided with means (12; 62) for aligning said circuit board (20) and said housing (10).

5. The method of claim 4, in which said housing (10) and said circuit board (20) are designed such that said circuit board (20) can be arranged within said housing in a single orientation.

6. The method of claim 4 or 5, in which said housing (10) is dimensioned to fit about the circumference of said circuit board (20).

7. The method of claim 6, in which in step c) said circuit board (20) is mounted within said housing (10) by snap-fit connection.

8. The method of any one the preceding claims, in which
- step a) comprises forming a plurality of openings (16) in said housing (10),
- step b) comprises injection molding a plurality of connector elements (30), each of which extends through one of said openings (16) and comprises a first end (32) located in the interior of the housing and a second end (34) terminating at the exterior of the housing; and
- step c) comprises mounting a circuit board (20) comprising a plurality of sensor elements (40) to the housing (10) such that each connector element (30) contacts one of said sensor elements.

9. The method of claim 8, wherein said sensor elements (40) are arranged to form a capacitive sensor element.

10. The method of any one the preceding claims, further comprising mounting a panel element (50) providing for a user interface such that the second end (34) of each of said connector elements (30) terminates at said panel element.

11. The method of claim 10, wherein the panel element (50) comprises a plastic foil which covers the connector element(s) (30).

12. The method of claim 11, wherein the panel element (50) comprises a PMMA foil.

13. The method of any one the preceding claims, in which step b) comprises injection molding a conductive rubber or a conductive plastics material.

## Patentansprüche

1. Verfahren zum Herstellen eines elektrischen Schaltelements, aufweisend:
a) Bereitstellen eines Gehäuses (10), aufweisend mindestens eine Öffnung (16),
b) Formen von mindestens einem Anschlusselement (30) durch Spritzgießen eines leitfähigen Materials in das Gehäuse (10) derart, dass das Anschlusselement sich über die Öffnung (16) des Gehäuses hinaus erstreckt und ein erstes Ende (32), das im Inneren des Gehäuses platziert ist, und ein zweites Ende (34), das am Äußeren des Gehäuses endet, aufweist;
c) Montage einer Leiterplatte (20), aufweisend ein Sensorelement (40), am Gehäuse (10) auf solche Weise, dass das erste Ende (32) des ersten Anschlusselements (30) das Sensorelement (40) berührt.

2. Verfahren nach Anspruch 1, wobei der Schritt a) ein Spritzgießen eines Kunststoffs zum Formen des Gehäuses (10) aufweist.

3. Verfahren nach Anspruch 1 oder 2, wobei das Gehäuse (10) zur Aufnahme der Leiterplatte (20) bemessen ist.

4. Verfahren nach einem der vorhergehenden Ansprüche, wobei in Schritt a) das Gehäuse (10) mit Mitteln (12; 62) zum Ausrichten der Leiterplatte (20) und des Gehäuses (10) bereitgestellt ist.

5. Verfahren nach Anspruch 4, wobei das Gehäuse (10) und die Leiterplatte (20) so konstruiert sind, dass die Leiterplatte (20) in einem einzigen Vorgang innerhalb des Gehäuses angeordnet werden kann.

6. Verfahren nach Anspruch 4 oder 5, wobei das Gehäuse (10) so bemessen ist, dass es um den Umkreis der Leiterplatte (20) passt.

7. Verfahren nach Anspruch 6, wobei in Schritt c) die Leiterplatte (20) durch eine Einrastverbindung innerhalb des Gehäuses (10) montiert ist.

8. Verfahren nach einem der vorhergehenden Ansprüche, wobei
- Schritt a) Formen mehrerer Öffnungen (16) im Gehäuse (10) aufweist;
- Schritt b) Spritzgießen mehrerer Anschlusselemente (30) aufweist, von denen sich jedes durch eine der Öffnungen (16) erstreckt und ein erstes Ende (32), das sich im Inneren des Gehäuses befindet, und ein zweites Ende (34), das am Äußeren des Gehäuses endet, aufweist; und
- Schritt c) Montage einer Leiterplatte (20), die mehrere Sensorelemente (40) aufweist, am Gehäuse (10) auf solche Weise, dass jedes Anschlusselement (30) in Kontakt mit einem der Sensorelemente ist.

9. Verfahren nach Anspruch 8, wobei die Sensorelemente (40) angeordnet sind, um ein kapazitives Sensorelement zu bilden.

10. Verfahren nach einem der vorhergehenden Ansprüche, ferner aufweisend Montage eines Tafelelements (50), das für eine Anwenderschnittstelle bereitgestellt ist, so dass das zweite Ende (34) jedes der Anschlusselemente (30) am Tafelelement endet.

11. Verfahren nach Anspruch 10, wobei das Tafelelement (50) eine Kunststofffolie aufweist, die das/die Anschlusselement (e) (30) bedeckt.

12. Verfahren nach Anspruch 11, wobei das Tafelelement (50) eine PMMA-Folie aufweist.

13. Verfahren nach einem der vorhergehenden Ansprüche, wobei Schritt b) Spritzgießen eines leitfähigen Gummis oder eines leitfähigen Kunststoffs aufweist.

## Revendications

1. Procédé de fabrication d'un élément de commutation électrique, comprenant :
a) fournir un boîtier (10) ayant au moins une ouverture (16),
b)former au moins un élément connecteur (30) par moulage par injection d'un matériau conducteur dans ledit boîtier (10), de sorte que l'élément connecteur s'étende à travers l'ouverture (16) dudit boîtier et comprenne une première extrémité (32) située à l'intérieur du boîtier et une seconde extrémité (34) qui se termine à l'extérieur du boîtier ;
c)monter une carte de circuit imprimé (20) comprenant un élément capteur (40) sur le boîtier (10) de sorte que la première extrémité (32) de l'élément connecteur (30) soit en contact avec l'élément capteur (40).

2. Procédé selon la revendication 1, dans lequel l'étape a) consiste à mouler par injection une matière plastique de sorte à former ledit boîtier (10).

3. Procédé selon la revendication 1 ou 2, dans lequel ledit boîtier (10) est dimensionné de sorte à recevoir ladite carte de circuit imprimé (20).

4. Procédé selon l'une quelconque des revendications précédentes, dans lequel dans l'étape a) ledit boîtier (10) est muni de moyens (12; 62) pour aligner ladite carte de circuit imprimé (20) et ledit boîtier (10).

5. Procédé selon la revendication 4, dans lequel ledit boîtier (10) et ladite carte de circuit imprimé (20) sont conçus de sorte que ladite carte de circuit imprimé (20) puisse être disposée à l'intérieur dudit boîtier selon une orientation unique.

6. Procédé selon la revendication 4 ou 5, dans lequel ledit boîtier (10) est dimensionné de manière à s'ajuster autour de la circonférence de ladite carte de circuit imprimé (20).

7. Procédé selon la revendication 6, dans lequel dans l'étape c) ladite carte de circuit imprimé (20) est montée à l'intérieur dudit boîtier (10) par assemblage à encliquetage.

8. Procédé selon l'une quelconque des revendications précédentes, dans lequel
- l'étape a) consiste à former une pluralité d'ouvertures (16) dans ledit boîtier (10),
- l'étape b) consiste à mouler par injection une pluralité d'éléments connecteurs (30), chacun d'entre eux s'étend à travers une desdites ouvertures (16) et comprend une première extrémité (32) située à l'intérieur du boîtier et une seconde extrémité (34) se terminant à l'extérieur du boîtier ; et
- l'étape c) consiste à monter une carte de circuit imprimé (20) comprenant une pluralité d'éléments capteurs (40) sur le boîtier (10) de sorte que chaque élément capteur (30) soit en contact avec un desdits éléments capteurs.

9. Procédé selon la revendication 8, dans lequel lesdits éléments capteurs(40) sont disposés pour former un élément capteur capacitif.

10. Procédé selon l'une quelconque des revendications précédentes, consistant en outre à monter un élément panneau (50) fournissant une interface utilisateur de sorte que la seconde extrémité (34) de chacun desdits éléments capteurs (30) se termine audit élément panneau.

11. Procédé selon la revendication 10, dans lequel l'élément panneau (50) contient une feuille plastique qui couvre l'élément ou les éléments connecteurs (30).

12. Procédé selon la revendication 11, dans lequel l'élément panneau (50) comprend une feuille de PMMA.

13. Procédé selon l'une quelconque des revendications précédentes, dans lequel l'étape b) consiste à mouler par injection un matériau conducteur en caoutchouc ou conducteur en plastique.
